# EUROPEAN PATENT SPECIFICATION

(11) **EP 0 828 255 B1**
(45) Date of publication and mention of the grant of the patent: **17.04.2002**
(21) Application number: 97101053.3
(22) Date of filing: 23.01.1997
(51) Int. Cl.: G11C 11/56

(54) **Data sensing apparatus and method of multi-bit cell**
Datenleseschaltungsanordnung und Verfahren für eine Mehrbitszelle
Dispositif de détection de données et méthode pour une cellule de type multibit

(30) Priority: 26.06.1996 KR 9624097
(43) Date of publication of application: 11.03.1998
(73) Proprietor: LG Semicon Co., Ltd., Cheongju-si, Chungcheongbuk-do (KR)
(72) Inventor: Choi, Woong Lim, Cheongju-si, Chungcheongbuk-do (KR)
(74) Representative: Urner, Peter, Dipl.-Phys.

(56) References cited:
- EP-A- 0 661 711
- EP-A- 0 724 266
- US-A- 5 163 021
- US-A- 5 508 958

## Description

### Field of the Invention

The present invention relates to an apparatus and method for reading out data from a semiconductor device, and more particularly, to a data sensing apparatus and method of multi-bit cell which reads out data in a memory cell programmed by two or more multi-level.

### Discussion of the Related Art

Generally, a semiconductor memory device comprises a volatile memory device which can store a new data after erasing a stored data and a nonvolatile memory device which permanently maintains a stored data. The volatile memory device includes a RAM which capable of performing data writing and data reading. The nonvolatile memory device includes a ROM, an EPROM and an EEPROM. The ROM is impossible to program, if once the data is stored. The EPROM and the EEPROM are possible to program again after erasing the stored data. The EPROM erases the stored data using an infrared ray. While the EEPROM electrically erases the stored data.

With development of communication industry, a memory device having high capacity is required and thus DRAM is widely used as storage media. However, the DRAM has a disadvantage to perform refresh operation for a certain time period since it requires a storage capacitor having a certain capacity. In this regard, the EEPROM without requiring the refresh operation has been constantly developed instead of the DRAM.

However, the EEPROM is possible to read only one data, for example, either "1" or "0" in a memory cell and thus it is required as much as memory cells which result in expensive cost per bit.

In order to avoid such problems, a multi-bit cell is actively being studied. Since the multi-bit memory cell stores data more than 2-bit in a memory cell, a storage integration of the data in a same chip can largely be improved without reducing the size of the memory cell.

Such a multi-bit memory cell is programmed by threshold voltages at multi-level per cell. That is, to store 2-bit data per cell, respective cell is programmed at four threshold voltage levels 2²=4, The four threshold voltage levels have logic values 00, 01, 10, 11, respectively.

To increase the number of bits per cell by programming many levels, it is required to precisely adjust the threshold voltage level. In addition, it is required to perform a precise sensing of the data programmed by multi-level at high speed.

A data sensing apparatus of a conventional multi-bit memory cell programmed by multi-bit will be described with reference to the appended drawings.

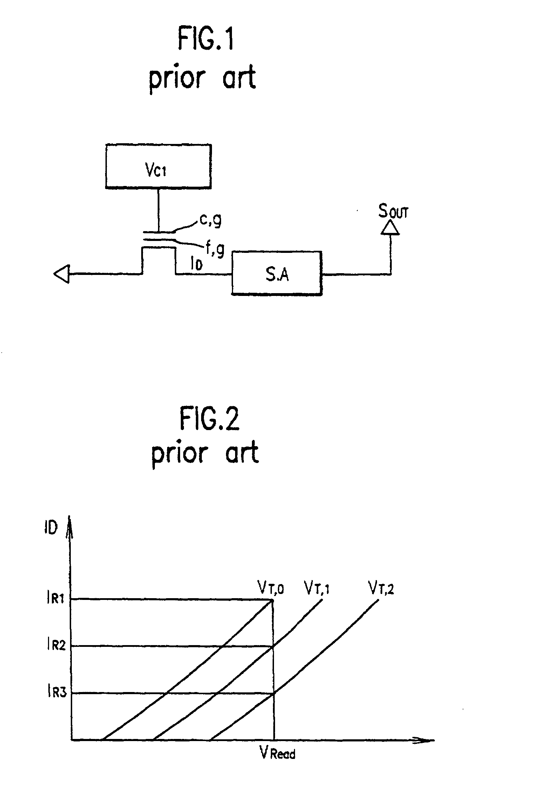

Fig. 1 is a configuration of a sensing apparatus of a conventional multi-bit memory cell. Fig. 2 is a graph showing operation of a sensing apparatus of a conventional multi-bit memory cell.

The data sensing method of the conventional multi-bit memory cell includes the steps of applying a certain voltage to a control gate to read data and determining the drain current from the applied voltage to read the multi-bit memory data.

As shown in Fig. 1, in the EEPROM having a floating gate F.G, a control gate C.G, a source region S and a drain region D, a sensing amplifier S.A is connected to the drain region D. At this time, the sensing amplifier S.A has a plurality of reference currents therein.

The data sensing method of the conventional multi-bit memory cell as aforementioned will be described below in detail.

First, it is supposed that the memory cell is programmed by threshold voltages of multi-level. That is, in case of data writing of 2 bits as shown in Fig. 2, the memory cell is programmed by one of four threshold voltages 0V, V_{T0}, V_{T1}, V_{T2} at the floating gate F.G. A certain voltage V_{READ} is selectively applied to the control gate C.G of the memory cell to read, upon applying a positive voltage to the source region S. Then, a drain current I_{D} corresponding to the state of the memory cell data programmed at the floating gate F.G is output to the sensing amplifier S.A.

The sensing amplifier S.A compares a reference current of multi-level therein with the drain current from the memory cell at different steps to read data.

As shown in Fig. 2, in case where the memory cell data to read in the EEPROM is programmed by the threshold voltage V_{T0} at the floating gate F.G, a drain current I_{R3} corresponding to the programmed data is output to the sensing amplifier S.A. While in case where it is programmed by the threshold voltage V_{T2} at the floating gate F.G, a drain current I_{R2} is output.

The sensing amplifier S.A compares a drain current from the memory cell with a reference current of multi-level therein to performing the data sensing.

However, the data sensing apparatus and method of the conventional multi-bit memory cell as aforementioned has several problems.

First, since the sensing amplifier must compare the currents from the memory cell at multi-level to read data, the sensing amplifier must have a reference current of multi-level. Thus, the size of the sensing amplifier becomes larger. In particular, since a large number of bits(128 bits) are required in a page mode read, the size of the chip as well as the sensing amplifier becomes larger.

In addition, since a plurality of reference currents must be supplied with the sensing amplifier, the consumption of the power is increased.

A data sensing apparatus as indicated in the preamble of claim 1 is known from EP-A-0 661 711.

### SUMMARY OF THE INVENTION

Accordingly, the present invention is directed to a data sensing apparatus and method of a multi-bit cell that substantially obviates one or more of the problems due to limitations and disadvantages of the related art.

An object of the present invention is to provide a data sensing apparatus and method of a multi-bit cell to reduce the size of a chip and the consumption of power.

The features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

The invention in specified by claims 1 and 8.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together will the description serve to explain the principles of the drawings:

In the drawings:
Fig. 1 is a configuration of a data sensing apparatus of a conventional multi-bit memory cell;
Fig. 2 is a graph showing operation of a data sensing apparatus of a conventional multi-bit memory cell;

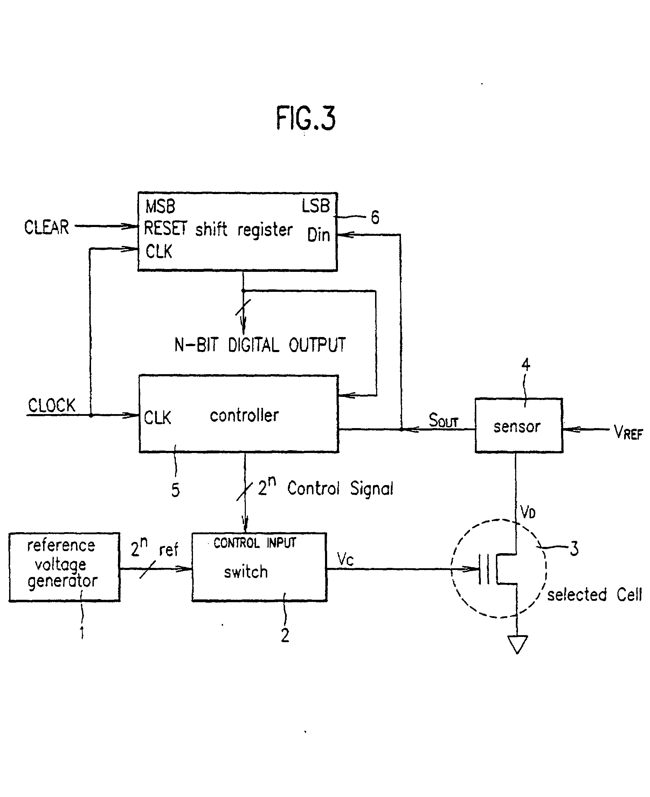

Fig. 3 is a configuration block of a data sensing apparatus of a multi-bit memory cell according to the embodiment of the present invention;
Fig. 4 is a detailed circuit diagram of a controller of Fig. 3;
Fig. 5 is a detailed circuit diagram of a decoder of Fig. 4;
Fig. 6 is a detailed circuit diagram of a switch of Fig. 3;
Fig. 7 is a sequence diagram showing a data sensing operation of a multi-bit memory cell according to the embodiment of the present invention;
Fig. 8 shows threshold voltages of m-bit cell and reference voltages corresponding to the threshold voltages according to the present invention;
Fig. 9 shows a selection of reference voltages according to the embodiment of the present invention;

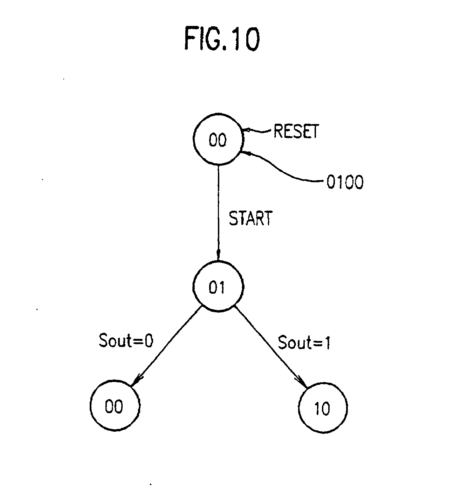

Fig. 10 is a sequence diagram of a data sensing method of a multi-bit memory cell according to the present invention; and

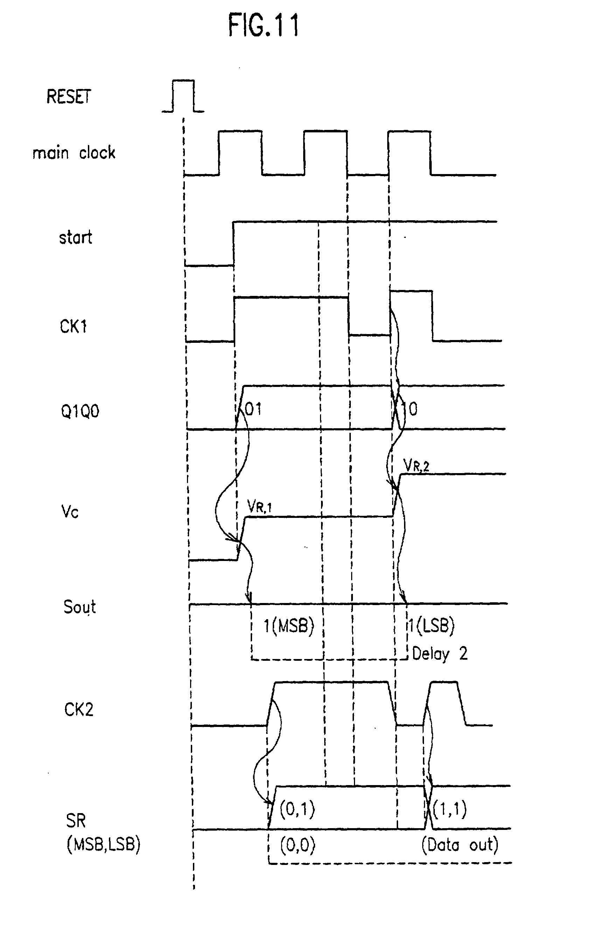

Fig. 11 is a timing chart of a data sensing method of a multi-bit memory cell according to the present invention.

### DETAILED DESCRIPTION OF THE PREFERRED EMBODIMENTS

A data sensing apparatus and method of a multi-bit memory cell according to the present invention will now be described in detail with reference to the accompanying drawings.

The data sensing apparatus of a multi-bit memory cell according to the present invention includes a reference voltage generator 1, a switch 2, a sensor 4, a shift resistor 6, and a controller 5. The reference voltage generator 1 outputs a plurality of reference voltages (2^{m}-1 voltages in case of m-bit). The switch 2 outputs one of a plurality of the reference voltages (2^{m}-1 voltages) to a control gate of a memory cell 4. The sensor 4 outputs a drain current value from the memory cell 3 in which a reference voltage is applied, in comparison with a reference value. The shift resistor 6 outputs m-bit data read out from the memory cell 3 by temporarily storing an output signal from the sensor 4. The controller 5 controls the switch 2 to output an intermediate reference voltage of reference voltages by inputting an outer clock signal and an output signal of the sensor 4, and to select an intermediate reference voltage of lower reference voltages or higher reference voltages than the current applied reference voltage upon determining the output signal of the sensor 4 if the intermediate reference voltage is applied.

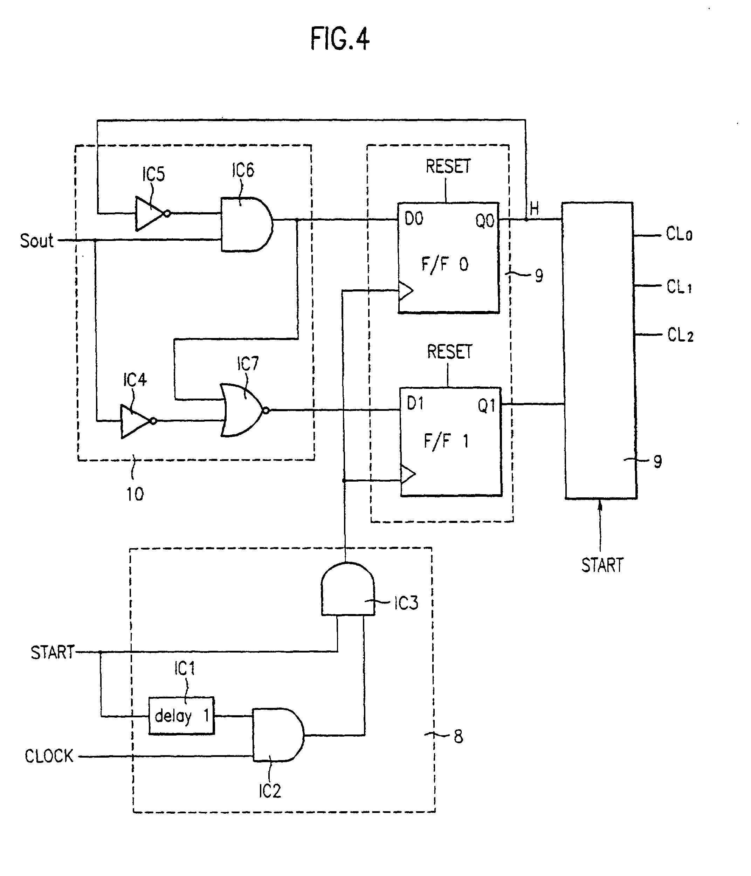

As shown in Fig. 4, the controller 5 includes a clock signal controller 8 for outputting a synchronization clock signal CL to perform a data sensing by logically operating a main clock signal CLOCK and a starting signal START, a latch 9 for latching signals input by the clock signal of the clock signal controller to output, a selector 10 for operating the output signal of the sensor 4 and the output signals of the latch 9 and outputting the operated output signals to an input terminal of the latch 9 to select a desired reference voltage, and a decoder 7 for outputting reference voltage selection signals CL0, CL1, CL2,... to the switch 2 by logically operating the output signals of the latch 9. The clock signal controller 8 includes a delay IC1 for outputting the starting signal START after delaying it for a certain time, a NAND gate IC2 for logically operating the output signal of the delay and the main clock signal CLOCK and reverse-outputting the signals, and a first AND gate IC3 for logically operating the output signal of the NAND gate IC2 and the starting signal START and outputting the signals to the clock signal of the latch 9.

The latch 9 includes first and second flip-flops F/F1, F/F2 for outputting a signal from the first AND gate IC3 of the clock signal controller 8 by latching it.

The selector 10 includes a first inverter IC4 for reversing the output signal of the sensor 4, a second inverter IC5 for reversing the output signal of the first flip-flop F/F1 for feedback, a second AND gate IC6 for logically operating an output signal of the second inverter IC5 and an output signal of the sensor 4 and outputting the signals to an input terminal of the first flip-flop F/F1, and a NOR gate for logically operating and reversing an output signal of the first inverter IC4 and an output signal of the second AND gate IC6 and outputting the signals to an input terminal of the second flip-flop F/F2.

Fig. 4 shows a controller 5 in case of 2-bit memory cell. In case of 2-bit or more memory cell, the configuration of a logic gate and a flip-flop depends on the number of bit.

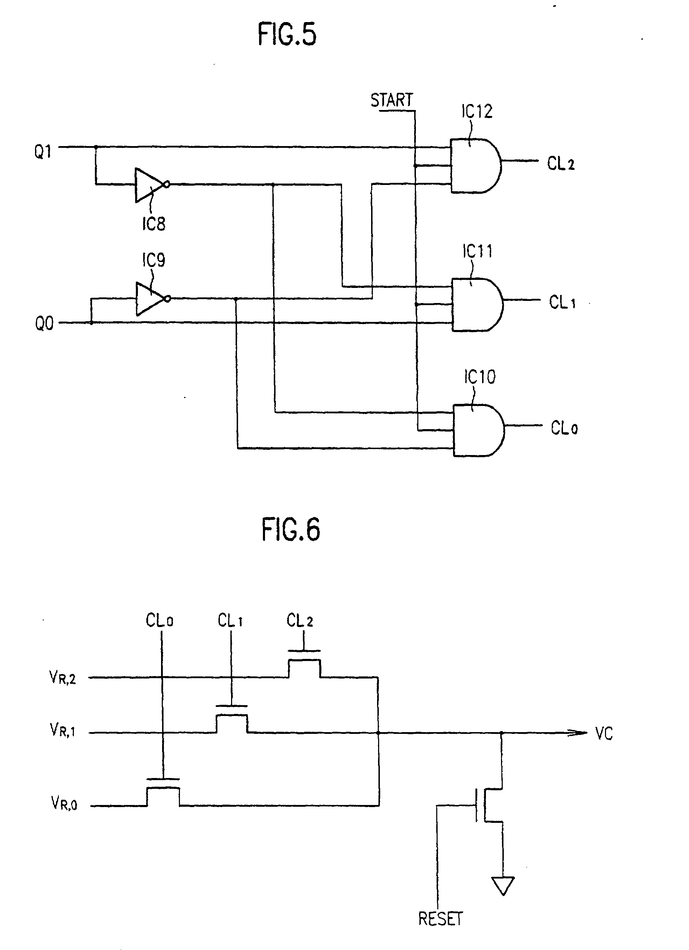

Referring to Fig. 5, the decoder 7 includes a third inverter IC8 for reversing an output signal of the first flip-flop F/F1, a fourth inverter IC9 for reversing an output signal of the second flip-flop F/F2, a third AND gate IC10 for logically operating the starting signal START and the third and fourth inverters IC8, IC9 to output a first reference voltage selection signal CL1, a fourth AND gate IC11 for logically operating the third inverter IC8, the starting signal START and the output signal of the second flip-flop F/F2, to output a second reference voltage selection signal, and a fifth AND gate IC12 for logically operating the fourth inverter IC9, the starting signal START and an output signal of the first flip-flop F/F1 to output a third reference voltage selection signal CL2.

The data sensing apparatus of a memory cell programmed by m-bit or more has includes the decoder 7 having 2^{m}-1 AND gates.

Referring to Fig. 6, the switch 2 includes a plurality of transistors Q1,Q2,Q3 for respectively switching a plurality of reference voltages(2^{m}-1 reference voltages) generated from the reference voltage generator 1 by the reference voltage selection signals CL1,CL2,CL3 of the controller 5, and a transistor Q4 for clearing a reference voltage being output to an output terminal from a plurality of the transistors Q1,Q2,Q3 by a reset signal RESET.

The data sensing method of a multi-bit memory cell according to the present invention will be described below with reference to the accompanying drawings.

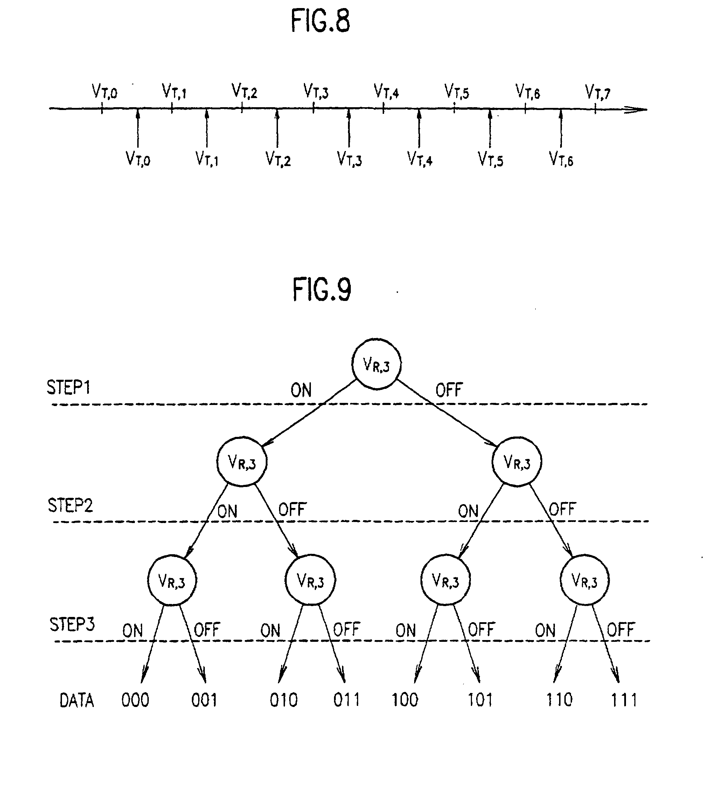

As shown in Fig. 8, a reference voltage is a value between respective threshold voltage values. For example, in case of a memory cell having multi-level of 3-bit, the threshold voltage may have eight levels.

The threshold voltage having eight levels may be V_{T,0}, V_{T,1}, V_{T,2}, V_{T,3}, V_{T,4}, V_{T,5}, V_{T,6}, V_{T,7}, and the reference voltage may be values between the respective threshold voltages, i.e., V_{R,0}, V_{R,1}, V_{R,2}, V_{R,3}, V_{R,4}, V_{R,5}, V_{R,6}, V_{R,7}.

In other words, if the threshold voltage is 1,2,3,4,5,6,7,8, the reference voltage becomes 1.5, 2.5, 3.5, 4.5, 5.5, 6.5, 7.5. Thus, in case of m-bit memory cell, the threshold voltage and the reference voltage may be 2^{m} and 2^{m}-1, respectively.

The reference voltage generator 1 generates the reference voltages set as above.

Three steps of applying the generated reference voltages to the control gate of the memory cell 3 in response to the output signal of the sensor 4 will be described with reference to Fig. 9.

First, if the reference voltage more than the threshold voltage programmed in the memory cell 3 is applied to the control gate of the memory cell 3, the memory cell is turned on. If the reference voltage less than the threshold voltage is applied to the control gate of the memory cell 3, the memory cell is not turned on. If the memory cell 3 is turned on, the sensor 4 outputs low signal. If not, the sensor 4 outputs high signal.

To simply explain the data sensing method according to the present invention, it is supposed that the lowest data 000 is programmed to the lowest threshold voltage and the highest data 111 is programmed to the highest threshold voltage, when the data is programmed in the multi-bit memory cell 3. It is also supposed that 3-bit data is programmed in one memory cell.

According to the data sensing method of the present invention, an intermediate (2^{m}/2nd) reference voltage of a plurality of (2^{m}-1) reference voltages is applied to the control gate of the memory cell if the starting signal is input.

That is, the reference voltage V_{R,3} of 7 reference voltages shown in Fig. 8 is applied to the control gate of the memory cell 3 in the first step.

On condition that the reference voltage V_{R,3} of the first step as aforementioned is applied to the control gate of the memory cell 3, if the output signal of the sensor 4 is low, the memory cell 3 is turned on and the programmed threshold voltage is lower than the applied reference voltage V_{R3}. That is, the threshold voltage programmed in the memory cell is one of V_{T0}, V_{T1}, V_{T2}, or V_{T3}.

On the contrary, on condition that the reference voltage V_{R3} of the first step is applied to the control gate of the memory cell 3, if the output signal of the sensor 4 is high, the memory cell 3 is turned off and the programmed threshold voltage is higher than the applied reference voltage V_{R,3}. That is, the threshold voltage programmed in the memory cell is one of V_{T,4}, V_{T,5}, V_{T,6}, or V_{T,7}.

Thus, on condition that the intermediate reference voltage V_{R,3} of the first step is applied to the control gate of the memory cell, if the output signal of the sensor 4 is low, the reference voltage lower than the reference voltage of the first step is applied to the control gate of the memory cell in the second step. On condition that the intermediate reference voltage V_{R,3} of the first step is applied to the control gate of the memory cell, if the output signal of the sensor 4 is high, the reference voltage higher than the reference voltage of the first step is applied to the control gate of the memory cell in the second step.

At this time, the intermediate reference voltage of lower reference voltages or higher reference voltages than the reference voltage of the first step is applied in the second step.

That is, on condition that the reference voltage V_{R,3} is applied, if the output signal of the sensor 4 is low, the intermediate (2^{m}/4th) reference V_{R,1} of lower reference voltages than the reference voltage V_{R,3} of the first step is applied in the second step. If the output signal of the sensor 4 is high, the intermediate (2^{m}/2+2^{m}/4th) reference voltage V_{R,5} of higher voltages than the reference voltage of the first step is applied in the second step.

On condition that the reference voltage V_{R3} or V_{R,3} of the second step is applied to the control gate of the memory cell, the above steps repeats upon checking the output signal of the sensor 4.

That is, on condition that the reference voltage V_{R,1} of the second step is applied to the control gate of the memory cell, if the output signal of the sensor 4 is low, the lower reference voltage V_{R,0} than the reference voltage V_{R,1} of the second step is applied to the control gate of the memory cell in the third step. On condition that the reference voltage V_{R,1} of the second step is applied to the control gate of the memory cell, if the output signal of the sensor 4 is high, the higher reference voltage V_{R,2} than the reference voltage V_{R,1} of the second step is applied to the control gate of the memory cell in the third step.

Further, on condition that the reference voltage V_{R,5} of the second step is applied to the control gate of the memory cell, the output signal of the sensor 4 is low, the lower reference voltage V_{R,4} than the reference voltage V_{R,5} of the second step is applied to the control gate of the memory cell in the third step. On condition that the reference voltage V_{R,5} of the second step is applied to the control gate of the memory cell, if the output signal of the sensor 4 is high, the higher reference voltage V_{R,6} than the reference voltage V_{R,3} of the second step is applied to the control gate of the memory cell in the third step.

In other words, in the third step, one of the reference voltages V_{R,0}, V_{R,2}, V_{R,4}, V_{R,6} is applied to the control gate of the memory cell.

Finally, the programmed data reading is performed in response to the reference voltage and the output signal of the sensor 4 in the third step.

That is, on condition that the reference voltage V_{R,0} is applied to the control gate of the memory cell, if the output signal of the sensor 4 is low, the data 000 is programmed. If the output signal of the sensor 4 is high, the data 001 is programmed.

Moreover, on condition that the reference voltage V_{R2} is applied to the control gate of the memory cell, if the output signal of the sensor 4 is low, the data 010 is programmed. If the output signal of the sensor 4 is high, the data 011 is programmed.

On condition that the reference voltage V_{R4} is applied to the control gate of the memory cell, if the output signal of the sensor is low, the data 100 is programmed. If the output signal of the sensor 4 is high, the data 101 is programmed.

On condition that the reference voltage V_{R6} is applied to the control gate of the memory cell, if the output signal of the sensor 4 is low, the data 110 is programmed. If the output signal of the sensor is high, the data 111 is programmed.

For data sensing in the memory cell for programming m-bit data (2^{m} threshold voltages), the reference voltage is m times applied. (For example, in case of 3-bit memory cell, the reference voltage is three times applied)

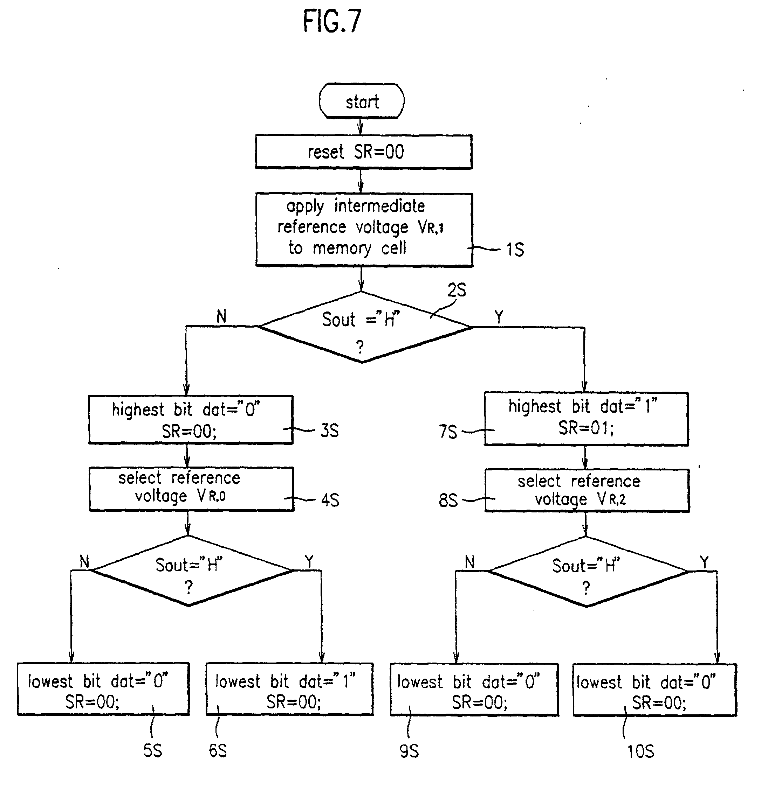

The operation of the data sensing apparatus of multi-bit memory cell as aforementioned will be described with reference to Fig. 7.

Fig. 7 shows the operation sequence in case of 2-bit data reading.

In case of 2-bit data sensing, three reference voltages are needed.

On condition that a main clock signal CLOCK is applied and reset, if the starting signal START is input, the intermediate reference voltage V_{R,1} of the controller 5 is applied to the control gate of the memory cell. (1S)

The sensing amplifier 4 detects the drain current of the memory cell having the applied reference voltage. Then, it outputs low signal if the drain current is detected, or high signal if not. (2S)

On condition that the initial intermediate reference voltage is applied to the control gate of the memory cell, if the output signal of the sensor 4 is low, the highest bit data "0" of sensing data is shifted in a shift register 6. (3S) The lower reference voltage V_{R,0} than the initial reference voltage is applied to the control gate of the memory cell 3 by the controller 5 in consistent with the next clock signal. (4S)

On condition that the reference voltage V_{R,0} is applied to the control gate of the memory cell, if the drain current of the memory cell detected by the sensor 4 is low, the lowest bit "0" of sensing data is shifted in the shift register 6. (5S) If the drain current is high, the lowest bit "1" of sensing data is shifted in the shift register 6. (6S)

If the output signal of the sensor 4 is high in the second step(2S), the highest bit "1" of sensing data is shifted in the shift register 6. (7S) The higher reference voltage V_{R,2} than the initial reference voltage is applied to the control gate of the memory cell 3 by the controller 5 in consistent with the next clock signal. (8S)

On condition that the reference voltage V_{R,2} is applied to the control gate of the memory cell, if the drain current of the memory cell detected by the sensor 4 is low, the lowest bit "0" of sensing data is shifted in the shift register 6. (9S) If the drain current is high, the lowest bit "1" of sensing data is shifted in the shift register 6. (10S)

As aforementioned, in case of 2-bit data, the reference voltage is twice applied to the control gate of the memory cell, and then data sensing is performed by outputting data from the highest bit to the lowest bit.

The operation of the controller 5 will be described with reference to Fig. 4.

At the initial state before inputting the starting signal, the the sensor 4 always outputs high signal and each of flip-flops F/F0,F/F1 outputs low signal.

Thus, the output signal of the first AND gate IC6 is high and the output signal of the NOR gate IC7 is low so that high signal is applied to the input terminal D0 of the first flip-flop F/F0 while low signal is applied to the input terminal D1 of the second flip-flop F/F1.

On condition that the main clock signal CLOCK is applied and reset, if the starting signal START is input to the delay IC1 of the controller 5 and the first AND gate IC3, the delay IC1 delays the starting signal for a certain time period to output it to the NAND gate IC2. The first AND gate IC3 outputs high signal for a delay time irrespective of the main clock signal. Therefore, the clock signal CK is applied to the first and second flip-flops F/F0, F/F1.

If the clock signal is applied to the first and second flip-flops F/F0, F/F1 as above, the first flip-flop F/F0 outputs high signal and the second flip-flop F/F1 outputs low signal.

Thus, as shown in Fig. 5, the decoder 7 outputs an intermediate selection signal CL1 of the reference voltage selection signals as high signal to apply the intermediate reference voltage V_{R,1} of three reference voltages to the control gate of the memory cell 3.

If the intermediate reference voltage V_{R,1} is applied to the memory cell 3, the output signal of the sensor 4 is varied depending on the program condition of the memory cell 3.

That is, if the memory cell 3 is programmed by a lower threshold voltage level than the intermediate reference voltage V_{R,1}, the sensor 4 outputs low signal. If it is programmed by a higher threshold voltage level than the intermediate reference voltage V_{R,1}, the sensor 4 outputs high signal.

As aforementioned, if the intermediate reference voltage V_{R,1} is applied to the control gate of the memory cell, the output signal of the sensor 4 is recognized by the controller 5, so that the lowest reference voltage or the highest reference voltage is selected again.

If the output signal of the sensor 4 is low, so does the output signal of the first NOR gate IC7 as well as the output signal of the first AND gate IC6. Thus, low signal is applied to the input terminals of the flip-flops F/F0, F/F1. Then, the starting signal delayed for a certain time period in the delay IC1 is applied to the NAND gate IC2. The NAND gate IC2 outputs the main clock signal by reversing it. The AND gate IC3 outputs the output signal from the NAND gate IC2 as clock signals of the respective flip-flops F/F0, F/F1.

Thus, the flip-flops F/F0, F/F1 output low signal to the decoder 7. The decoder 7 outputs the reference voltage selection signal CL0 as high signal to select the lowest reference voltage V_{R,0}.

On the contrary, if the output signal of the sensor 4 is high on condition that the intermediate reference voltage V_{R1} is applied to the control gate of the memory cell, low signal is applied to the input terminal of the first flip-flop F/F0 and high signal is applied to the same of the second flip-flop F/F1. Thus, the respective flip-flops output low signal and high signal, respectively as clock signal. The decoder 7 outputs the highest reference voltage V_{R,2}.

As aforementioned, the controller 5 allows the intermediate reference voltage V_{R,1} to be applied to the control gate of the memory cell in the instant of delay of the starting signal of high state and also allows the sensor 4 to output a lower reference voltage V_{R,0} or a higher reference voltage V_{R,2} of the reference voltages.

The reference voltage from the sensor 4 is applied to the controller 5, and then it is finally applied to the shift register 6 to output the data.

That is, if the output signal of the sensor 4 is high on condition that the intermediate reference voltage V_{R,1} is applied to the control gate of the memory cell, the controller 5 allows a higher reference voltage V_{R,2} than the intermediate reference voltage V_{R,1} to be applied to the control gate of the memory cell 3. At the same time, the data 01 is stored in the shift register 6. If the output signal of the sensor 4 is low, the controller 5 allows a lower reference voltage V_{R,0} than the intermediate reference voltage V_{R,1} to be applied to the control gate of the memory cell and the data 00 is stored in the shift register 6 at the same time.

Further, if the output signal of the sensor is high on condition that a higher reference voltage V_{R,2} than the intermediate reference voltage V_{R,1} is applied to the control gate of the memory cell, the data 11 is stored in the shift register 6. While if the output signal of the sensor is low, the data 1 is stored in the shift register 6.

As aforementioned, in case where the memory cell is programmed by multi-level of 2-bit, the reference voltage is twice applied and the data 11, 10, 01, or 00 is output depending on the output signal of the sensor 4.

The data sensing apparatus and method of a multi-bit memory cell according to the present invention as aforementioned has the following effects.

Since reference voltages of multi-level are applied to the control gate of the memory for the data sensing operation, the size of the sensing amplifier as well as the power consumption can be reduced.

In addition, since m-bit memory cell is programmed by 2^{m} threshold voltages to perform the data sensing by applying the reference voltage m times, the data sensing speed can be improved and the power consumption can be reduced.

It will be apparent to those skilled in the art that various modifications and variations can be made in the method for fabricating a phase shifted mask of the present invention without departing from the scope of the invention. Thus, it is intended that the present invention cover the modifications and variations of the invention provided they come within the scope of the appended claims and their equivalents.

## Claims

1. A data sensing apparatus of a multi-bit memory cell comprising:
a reference voltage generating means (1) for generating a plurality of reference voltages;
a switching means (2) for outputting one (Vc) of a plurality of the reference voltages generated from the reference voltage generating means to a control gate of the memory cell (3);
a sensing means (4) for sensing an output signal of the memory cell in which the reference voltage is applied;
a control means (5) for controlling the switching means to apply the most intermediate reference voltage to the control gate and to apply an intermediate reference voltage of lower reference voltages than the current applied reference voltage or higher reference voltages than the current applied reference voltage in response to an output signal of the sensing means; and
**characterized by** a shifting means (6) for storing and shifting therein the output signal of the sensing means in response to the application of said reference voltages to said control gate.

2. The sensing device of a multi-bit memory cell according to claim 1, wherein the control means comprises:
a clock signal controller for outputting a synchronization clock signal to perform a data sensing by logically operating a main clock signal and a starting signal;
a latch for latching a signal input by the clock signal of the clock signal controller to output;
a selector for operating the output signal of the sensing means and the output signal of the latch and outputting the operated output signals to an input terminal of the latch to select a desired reference voltage; and
a decoder for outputting a final reference voltage selection signal by logically operating the output signal of the latch.

3. The data sensing apparatus of a multi-bit memory cell according to claim 2, wherein the clock signal controller comprises:
a delay for outputting a starting signal after delaying it for a certain time;
a NAND gate for logically operating the output signal of the delay and an outer main clock signal and outputting the signals by reversing them; and
a first AND gate for logically operating the output signal of the NAND gate and the starting signal and outputting the signals to a clock signal of the latch.

4. The data sensing apparatus of a multi-bit memory cell according to claim 2, wherein the latch comprises first and second flip-flops for outputting an input signal from the clock signal controller by latching it.

5. The data sensing apparatus of a multi-bit memory cell according to claim 2, wherein the selector comprises:
a first inverter for reversing the output signal of the sensing means;
a second inverter for reversing the output signal of the first flip-flop for feedback;
a second AND gate for logically operating an output signal of the second inverter and the output signal of the sensing means and outputting the signals to an input terminal of the first flip-flop; and
a NOR gate for logically operating and reversing an output signal of the first inverter and an output signal of the second AND gate and outputting the signals to an input terminal of the second flip-flop.

6. The data sensing apparatus of a multi-bit memory cell according to claim 2, wherein the decoder comprises:
a third inverter for reversing the output signal of the first flip-flop;
a fourth inverter for reversing an output signal of the second flip-flop;
a third AND gate for logically operating the third and fourth inverters and the starting signal to output a first reference voltage selection signal;
a fourth AND gate for logically operating the third inverter, the starting signal, and the output signal of the second flip-flop to output a second reference voltage selection signal; and
a fifth AND gate for logically operating the fourth inverter, the starting signal, and the output signal of the first flip-flop to output a third reference voltage selection signal.

7. The data sensing apparatus of a multi-bit memory cell according to claim 2, wherein the switching means comprises:
a plurality of transistors for respectively switching a plurality of reference voltages generated from the reference voltage generating means by the reference voltage selection signal of the control means; and
a transistor for clearing a reference voltage being output to an output terminal from a plurality of the transistors by a reset signal.

8. A data sensing method of a multi-bit memory cell programmed by m-bit comprising three steps of:
a first step for generating 2^{m}-1 different reference voltages;
a second step for applying an intermediate reference voltage from the reference voltages to the control gate of the memory cell and outputting the highest bit data "0" or "1" depending on whether a drain current of the memory cell is detected or not; and
a third step for applying an intermediate reference voltage from lower reference voltages than the current applied reference voltage to the control gate of the memory cell if the drain current is detected in the second step, and applying an intermediate reference voltage from higher reference voltages than the current applied reference voltage to the control gate of the memory cell if the drain current is not detected, so as to output the lowest bit data by repeatedly outputting data depending on whether the drain current of the memory cell is detected or not.

9. The data sensing method of a multi-bit memory cell according to claim 8, wherein the corresponding bit data "0" is output if the drain current of the memory cell is detected or the corresponding bit data "1" is output if the drain current of the memory cell is not detected.

10. The data sensing method of a multi-bit memory cell according to claim 8, wherein the third step repeats m-1 times.

## Patentansprüche

1. Datenlesevorrichtung einer Mehrbit-Speicherzelle, mit:
- einer Bezugsspannungs-Erzeugungseinrichtung (1) zum Erzeugen mehrerer Bezugsspannungen;
- einer Schalteinrichtung (2) zum Ausgeben einer (Vc) von mehreren von der Bezugsspannungs-Erzeugungseinrichtung erzeugten Bezugsspannungen an ein Steuergate der Speicherzelle (3);
- einer Erfassungseinrichtung (4) zum Erfassen des Ausgangssignals der Speicherzelle, an die die Bezugsspannung angelegt wird;
- einer Steuerungseinrichtung (5) zum Steuern der Schalteinrichtung zum Anlegen der mittelsten Bezugsspannung an das Steuergate, und zum Anlegen einer mittleren Bezugsspannung von Bezugsspannungen, die niedriger als die aktuell angelegte Bezugsspannung sind, oder Bezugsspannungen, die höher als die aktuell angelegte Bezugsspannung sind, auf ein Ausgangssignal der Erfassungseinrichtung hin;
**gekennzeichnet durch** eine Verschiebeeinrichtung (6) zum Speichern und Verschieben des Ausgangssignals der Erfassungseinrichtung auf das Anlegen der Bezugsspannungen an das Steuergate.

2. Datenlesevorrichtung einer Mehrbit-Speicherzelle nach Anspruch 1, bei der die Steuerungseinrichtung Folgendes aufweist:
- eine Taktsignal-Steuerungseinrichtung zum Ausgeben eines synchronisierenden Taktsignals zum Ausführen eines Datenerfassungsvorgangs dadurch, dass ein Haupttaktsignal und ein Startsignal einer logischen Operation unterzogen werden;
- eine Latchstufe zum Zwischenspeichern eines auszugebenden Signals, das beim Taktsignal der Taktsignal-Steuerungseinrichtung aufgenommen wird;
- einen Selektor, um das Ausgangssignal der Erfassungseinrichtung und das Ausgangssignal der Latchstufe einer Operation zu unterziehen und um die der Operation unterzogenen Ausgangssignale an einen Eingangsanschluss der Latchstufe auszugeben, um eine gewünschte Bezugsspannung auszuwählen; und
- einen Decoder zum Ausgeben eines abschließenden Bezugsspannungs-Auswählsignals dadurch, dass das Ausgangssignal der Latchstufe einer logischen Operation unterzogen wird.

3. Datenlesevorrichtung einer Mehrbit-Speicherzelle nach Anspruch 2, **dadurch gekennzeichnet, dass** die Taktsignal-Steuerungseinrichtung Folgendes aufweist:
- eine Verzögerungseinheit zum Ausgeben eines Startsignals nach einem Verzögern desselben um eine bestimmte Zeit;
- ein NAND-Gatter, um das Ausgangssignal der Verzögerungseinheit und ein äußeres Haupttaktsignal einer logischen Operation zu unterziehen und die Signale unter Umkehr derselben auszugeben; und
- ein erstes UND-Gatter, um das Ausgangssignal des NAND-Gatters und das Startsignal einer logischen Operation zu unterziehen und die Signale hinsichtlich eines Taktsignals der Latchstufe auszugeben.

4. Datenlesevorrichtung einer Mehrbit-Speicherzelle nach Anspruch 2, bei der die Latchstufe ein erstes und ein zweites Flipflop aufweist, um ein Eingangssignal von der Taktsignal-Steuerungseinrichtung durch Zwischenspeichern desselben auszugeben.

5. Datenlesevorrichtung einer Mehrbit-Speicherzelle nach Anspruch 2, bei der der Selektor Folgendes aufweist:
- einen ersten Inverter zum Umkehren des Ausgangssignals der Erfassungseinrichtung;
- einen zweiten Inverter zum Umkehren des Ausgangssignals des ersten Flipflops zur Rückkopplung;
- ein zweites UND-Gatter, um das Ausgangssignal des zweiten Inverters und das Ausgangssignal der Erfassungseinrichtung einer logischen Operation zu unterziehen und um die Signale an einen Eingangsanschluss des ersten Flipflops auszugeben; und
- ein NOR-Gatter, um das Ausgangssignal des ersten Inverters und das Ausgangssignal des zweiten UND-Gatters einer logischen Operation zu unterziehen und zu invertieren und die Signale an einen Eingangsanschluss des zweiten Flipflops auszugeben.

6. Datenlesevorrichtung einer Mehrbit-Speicherzelle nach Anspruch 2, bei der der Decoder Folgendes aufweist:
- einen dritten Inverter zum Invertieren des Ausgangssignals des ersten Flipflops;
- einen vierten Inverter zum Invertieren des Ausgangssignals des zweiten Flipflops;
- ein drittes UND-Gatter, um den dritten und den vierten Inverter und das Startsignal einer logischen Operation zu unterziehen, um ein erstes Bezugsspannungs-Auswählsignal auszugeben;
- ein viertes UND-Gatter, um den dritten Inverter, das Startsignal und das Ausgangssignal des zweiten Flipflops einer logischen Operation zu unterziehen und ein zweites Bezugsspannungs-Auswählsignal auszugeben; und
- ein fünftes UND-Gatter, um den vierten Inverter, das Startsignal und das Ausgangssignal des ersten Flipflops einer logischen Operation zu unterziehen und ein drittes Bezugsspannungs-Auswählsignal auszugeben.

7. Datenlesevorrichtung einer Mehrbit-Speicherzelle nach Anspruch 2, bei der die Schalteinrichtung Folgendes aufweist:
- mehrere Transistoren zum jeweiligen Schalten mehrerer von der Bezugsspannungs-Erzeugungseinrichtung erzeugter Bezugsspannungen durch das Bezugsspannungs-Auswählsignal der Steuerungseinrichtung; und
- einen Transistor zum Löschen einer Bezugsspannung, die von mehreren der Transistoren an einen Ausgangsanschluss ausgegeben wird, mittels eines Rücksetzsignals.

8. Datenleseverfahren für eine mit m Bits programmierte Mehrbit-Speicherzelle, mit den folgenden drei Schritten:
- einem ersten Schritt zum Erzeugen von 2^{m}-1 verschiedenen Bezugsspannungen;
- einem zweiten Schritt zum Anlegen einer mittleren Bezugsspannung unter den Bezugsspannungen an das Steuergate der Speicherzelle und zum Ausgeben des höchsten Bitdatenwerts "0" oder "1" abhängig davon, ob ein Drainstrom der Speicherzelle erfasst wird oder nicht; und
- einem dritten Schritt zum Anlegen einer mittleren Bezugsspannung aus Bezugsspannungen unter der aktuell angelegten Bezugsspannung an das Steuergate der Speicherzelle, wenn beim zweiten Schritt ein Drainstrom erfasst wird, und zum Anlegen einer mittleren Bezugsspannung aus Bezugsspannungen über der aktuell angelegten Bezugsspannung an das Steuergate der Speicherzelle, wenn kein Drainstrom erfasst wird, um den niedrigsten Bitdatenwert dadurch auszugeben, dass Daten wiederholt abhängig davon ausgegeben werden, ob der Drainstrom der Speicherzelle erfasst wird oder nicht.

9. Datenleseverfahren für eine Mehrbit-Speicherzelle nach Anspruch 8, bei dem der entsprechende Bitdatenwert "0" ausgegeben wird, wenn ein Drainstrom der Speicherzelle erfasst wird, oder der entsprechende Bitdatenwert "1" ausgegeben wird, wenn kein Drainstrom der Speicherzelle erfasst wird.

10. Datenleseverfahren für eine Mehrbit-Speicherzelle nach Anspruch 8, bei dem der dritte Schritt m-1 mal wiederholt wird.

## Revendications

1. Un dispositif de captage de données d'une cellule de mémoire à bits multiples, comprenant :
- des moyens de génération d'une tension de référence (1) pour générer une pluralité de tensions de référence ;
- des moyens de commutation (2) pour fournir en sortie (Vc) l'une parmi une pluralité de tensions de référence générées par les moyens de génération d'une tension de référence, via une porte de commande de la cellule mémoire ;
- des moyens de captage (4) pour capter un signal de sortie de la cellule mémoire à laquelle est appliquée la tension de référence ;
- des moyens de commande (5) pour commander les moyens de commutation afin d'appliquer à la porte de commande la tension de référence la plus intermédiaire et pour appliquer une tension de référence intermédiaire de tensions de référence inférieures à la tension de référence actuellement appliquée ou de tensions de référence supérieures à la tension de référence actuellement appliquée, en réponse à un signal de sortie des moyens de captage ;
et **caractérisé par**
- des moyens de décalage (6) pour stocker et pour décaler le signal de sortie des moyens de captage en réponse à l'application desdites tensions de référence à ladite porte de commande.

2. Le dispositif de captage d'une cellule mémoire à bits multiples selon la revendication 1, dans lequel les moyens de commande comprennent :
- un organe de commande d'un signal d'horloge pour fournir en sortie un signal d'horloge de synchronisation pour effectuer le captage des données grâce à une opération logique sur un signal d'horloge principal et un signal de départ ;
- un registre de stockage temporaire pour verrouiller temporairement un signal fourni en entrée par le signal d'horloge de l'organe de commande du signal d'horloge, à fournir en sortie ;
- un sélecteur pour traiter le signal de sortie des moyens de captage et le signal de sortie du registre de stockage temporaire et pour fournir en sortie les signaux de sortie ainsi traités vers une borne d'entrée du registre de stockage temporaire afin de sélectionner une tension de référence recherchée ; et
- un décodeur pour fournir en sortie un signal de sélection d'une tension de référence finale en traitant par une opération logique le signal de sortie du registre de stockage temporaire.

3. Le dispositif de captage de données pour une cellule de mémoire à bits multiples selon la revendication 2, dans lequel l'organe de commande du signal d'horloge comprend :
- un retardateur pour fournir en sortie un signal de début après y avoir appliqué un retard d'une certaine durée ;
- une porte NON-ET pour effectuer une opération logique sur le signal de sortie du retardateur et un signal d'horloge principal externe et en fournissant en sortie les signaux en les inversant ; et
- une première porte ET pour effectuer une opération logique sur le signal de sortie de la porte NON-ET et le signal de départ, et en fournissant en sortie les signaux vers un signal d'horloge du registre de stockage temporaire.

4. Le dispositif de captage de données pour une cellule de mémoire à bits multiples selon la revendication 2, dans lequel le registre de stockage temporaire comprend une première et une deuxième bascules pour fournir en sortie un signal d'entrée originaire de l'organe de commande du signal d'horloge en le verrouillant temporairement.

5. Le dispositif de captage de données pour une cellule de mémoire à bits multiples selon la revendication 2, dans lequel le sélecteur comprend :
- un premier inverseur pour inverser le signal de sortie des moyens de captage ;
- un deuxième inverseur pour inverser le signal de sortie de la première bascule par rétroaction ;
- une deuxième porte ET pour effectuer une opération logique sur un signal de sortie du deuxième inverseur et le signal de sortie des moyens de captage, et pour fournir en sortie les signaux vers une borne d'entrée de la première bascule ; et
- une porte NON-OU pour effectuer une opération logique et pour inverser un signal de sortie du premier inverseur et un signal de sortie de la deuxième porte ET et pour fournir en sortie les signaux vers une borne d'entrée de la deuxième bascule.

6. Le dispositif de captage de données pour une cellule de mémoire à bits multiples selon la revendication 2, dans lequel le décodeur comprend :
- un troisième inverseur pour inverser le signal de sortie de la première bascule ;
- un quatrième inverseur pour inverser un signal de sortie de la deuxième bascule ;
- une troisième porte ET pour effectuer une opération logique sur le troisième et le quatrième inverseurs et le signal de départ, afin de fournir en sortie un premier signal de sélection d'une tension de référence ;
- une quatrième porte ET pour effectuer une opération logique sur le troisième inverseur, le signal de départ et le signal de sortie de la deuxième bascule, pour fournir en sortie un deuxième signal de sélection de tension de référence ; et
- une cinquième porte ET pour effectuer une opération logique sur le quatrième inverseur, le signal de départ et le signal de sortie de la première bascule, pour fournir en sortie un troisième signal de sélection d'une tension de référence.

7. Le dispositif de captage de données pour une cellule de mémoire à bits multiples selon la revendication 2, dans lequel les moyens de commutation comprennent :
- une pluralité de transistors pour commuter respectivement une pluralité de tensions de référence générées par les moyens de génération de tension de référence grâce au signal de sélection de tension de référence des moyens de commande ; et
- un transistor pour effacer une tension de référence en train d'être sortie vers une borne de sortie à partir d'une pluralité des transistors, au moyen d'un signal de remise à zéro.

8. Le dispositif de captage de données pour une cellule de mémoire à bits multiples programmée par m-bits, comprenant les trois étapes suivantes :
- une première étape, de génération de 2^{m}-1 tensions de référence différentes ;
- une deuxième étape d'application d'une tension de référence intermédiaire parmi les tensions de référence à la porte de commande de la cellule mémoire et pour fournir en sortie une donnée "0" ou "1" du bit de poids fort en fonction du fait que oui ou non un courant de drain de la cellule mémoire est détecté ou pas ; et
- une troisième étape d'application d'une tension de référence intermédiaire parmi des tensions de référence inférieures à la tension de référence actuellement appliquée à une porte de commande de la cellule mémoire si le courant de drain est détecté lors de la deuxième étape, et à appliquer une tension de référence intermédiaire parmi les tensions de référence supérieures à la tension de référence actuellement appliquée à la porte de commande de la cellule mémoire dans le cas où le courant de drain n'est pas détecté, afin de fournir en sortie les données du bit de poids le plus faible en fournissant en sortie les données de façon répétitive en fonction du fait que le courant de drain de la cellule mémoire est détecté ou pas.

9. Le procédé de captage de données pour une cellule mémoire à bits multiples selon la revendication 8, dans lequel la donnée "0" du bit correspondant est fournie en sortie dans le cas où le courant de drain de la cellule mémoire est détecté ou pour fournir en sortie la donnée "1" du bit correspondant dans le cas où le courant de drain de la cellule mémoire n'est pas détecté.

10. Le procédé de captage de données pour une cellule mémoire à bits multiples selon la revendication 8, dans lequel la troisième étape est répétée m-1 fois.
